Europäisches Patentamt

European Patent Office

Office européen des brevets

(19)

(11) Veröffentlichungsnummer: **0 460 286 A2**

## (12) EUROPÄISCHE PATENTANMELDUNG

(21) Anmeldenummer: **90123453.4**

(22) Anmeldetag: **06.12.90**

(51) Int. Cl.⁵: **H01L 21/603**

(30) Priorität: **06.06.90 DE 4018131**

(43) Veröffentlichungstag der Anmeldung:
**11.12.91 Patentblatt 91/50**

(84) Benannte Vertragsstaaten:
**CH DE FR GB IT LI SE**

(71) Anmelder: **SIEMENS AKTIENGESELLSCHAFT**
**Wittelsbacherplatz 2**
**W-8000 München 2(DE)**

(72) Erfinder: **Schwarzbauer, Herbert, Dr.**
**Kössener Strasse 13 a**
**W-8000 München 70(DE)**

(54) **Verfahren und Anordnung zum Verbinden von einem Halbleiter mit einem Substrat oder zur Nachbehandlung einer Halbleiter/Substrat-Verbindung durch berührungsfreies Pressen.**

(57) Die Erfindung betrifft Verfahren, bei denen durch ein chemisch inertes und nicht festes Medium Druck auf eine Halbleiteroberfläche (0) ausgeübt wird, wobei zum Beispiel mit Hilfe einer Abdichtung (6a) verhindert wird, daß sich ein Gegendruck in einer Zwischenschicht (2) aufbaut. Eine Verbindung zwischen dem Halbleiter (3) und dem Substrat (1) erfolgt durch Drucksintern oder durch Diffusionsschweißen. Eine Berührung zwischen einem aktivem, inneren Bereich des Halbleiters und einem Preßkolben kann dadurch vermieden werden, daß der Preßkolben einen erhabenen und ringförmigen äußeren Bereich zur Abdichtung besitzt und der eigentliche Preßdruck durch das Druckmedium über eine im Preßkolben befindliche Bohrung bewirkt wird. Dieser erhabene Rand zur Abdichtung kann sich, anstatt auf dem Preßkolben, auch auf dem Halbleiter befinden. Wird ein Halbleiterbauelement mit einer Kunststoffschmelze umspritzt, so kann diese Kunststoffschmelze selbst als Druckmedium dienen.

EP 0 460 286 A2

Die Erfindung bezieht sich auf Verfahren zum Verbinden eines Halbleiters mit einem Substrat oder zur Nachbehandlung einer Halbleiter/Substrat-Verbindung durch Pressen sowie auf Anordnungen zu deren Durchführung.

Zur Erhöhung der mechanischen Stabilität und zur besseren Wärmeableitung werden Halbleiter oftmals mit Metallsubstraten verbunden. Meist werden dazu Verbindungstechniken wie Kleben oder Löten verwendet, die schnell, billig und vollautomatisch durchführbar sind. Die Temperaturbeständigkeit und die Temperaturwechselfestigkeit, besonders bei Chipgrößen von mehreren Millimetern Kantenlänge, sind dabei jedoch begrenzt. Beim Kleben von Halbleitern und besonders bei Leistungshalbleitern wirkt sich zudem der thermische und elektrische Widerstand des Klebers nachteilig aus.

Eine hochfeste Verbindung kann mit niedrigem thermischen und elektrischen Widerstand durch Drucksintern einer Silberpulverschicht nach EP-A-242 626 erzielt werden. Dabei wird ein Preßdruck jeweils durch starre Stempel auf die zu verbindenen Teile aufgebracht. Die Oberseite des Halbleiters wird in diesem Preßverfahren durch ein druckübertragendes festes Medium gänzlich berührt.

Aus der EP-330 896 und der EP-330 895 ist weiterhin bekannt, das Substrat und den Halbleiter in eine elastische Zentrierform, zum Beispiel aus Silikonkautschuk, einzubetten, die den Preßdruck eines bewegbaren Stempels überträgt, indem sie bei Erreichen des Sinterdrucks den verbleibenden Innenraum einer Aufnahmekammer, in der sich das Substrat und der Halbleiterkörper befinden, vollständig ausfüllt. Bei diesen bekannten Preßverfahren ist ein Kontakt zwischen einem festen Medium und der Oberseite des Halbleiterkörpers notwendig, wobei es oftmals zu Verunreinigungen der Halbleiteroberfläche kommt.

Der Erfindung liegt die Aufgabe zugrunde, Verfahren der eingangs genannten Art anzugeben, bei denen Halbleiter mit Substraten in vorteilhafter Weise durch Pressen verbunden werden oder bereits vorverbundene Halbleiter/Substrat-Verbindungen in vorteilhafter Weise durch Pressen nachbehandelt werden. Dies wird erfindungsgemäß durch eine Ausbildung der Verfahren nach den kennzeichnenden Teilen der Patentansprüche 1 oder 2 erreicht.

Die durch die Erfindung erreichten Vorteile sind im wesentlichen darin zu sehen, daß die aktive Fläche der Halbleiter nicht von aufliegenden Teilen berührt und verunreinigt wird, daß keine mechanischen Spannungsspitzen im Halbleitermaterial auftreten und daß auch mehrere Halbleiter/Substrat-Verbindungen in einem Arbeitsgang hergestellt oder nachbehandelt werden können.

Die Patentansprüche 3 bis 12 und 15 bis 17 sind auf vorteilhafte Weiterbildungen der erfindungsgemäßen Verfahren gerichtet. Die Patentansprüche 13 und 14 betreffen vorteilhafte Anordnungen zur Durchführung der Verfahren nach den Patentansprüchen 10 oder 11. Der Patentanspruch 18 ist auf eine vorteilhafte Anordnung zur Durchführung des Verfahrens nach Patentanspruch 15 gerichtet.

Im folgenden werden bevorzugte Ausführungsbeispiele der Erfindung anhand der Zeichnung näher erläutert. Es zeigt:

Figur 1     eine erste Darstellung zur Erläuterung eines ersten erfindungsgemäßen Verfahrens,

Figur 2     eine zweite Darstellung zur Erläuterung des ersten erfindungsgemäßen Verfahrens,

Figur 3     eine dritte Darstellung zur Erläuterung des ersten erfindungsgemäßen Verfahrens,

Figur 4     eine Darstellung zur Erläuterung eines zweiten erfindungsgemäßen Verfahrens,

Figur 5a    eine erste Anordnung zur Durchführung des ersten erfindungsgemäßen Verfahrens,

Figur 5b    eine zweite Anordnung zur Durchführung des ersten erfindungsgemäßen Verfahrens,

Figur 6a    eine erste Anordnung zur Durchführung des zweiten erfindungsgemäßen Verfahrens,

Figur 6b    eine zweite Anordnung zur Durchführung des zweiten erfindungsgemäßen Verfahrens,

Figur 7     eine andere Anordnung zur Durchführung des ersten oder zweiten erfindungsgemäßen Verfahrens und

Figur 8     eine weitere Anordnung zur Durchführung des ersten oder zweiten erfindungsgemäßen Verfahrens.

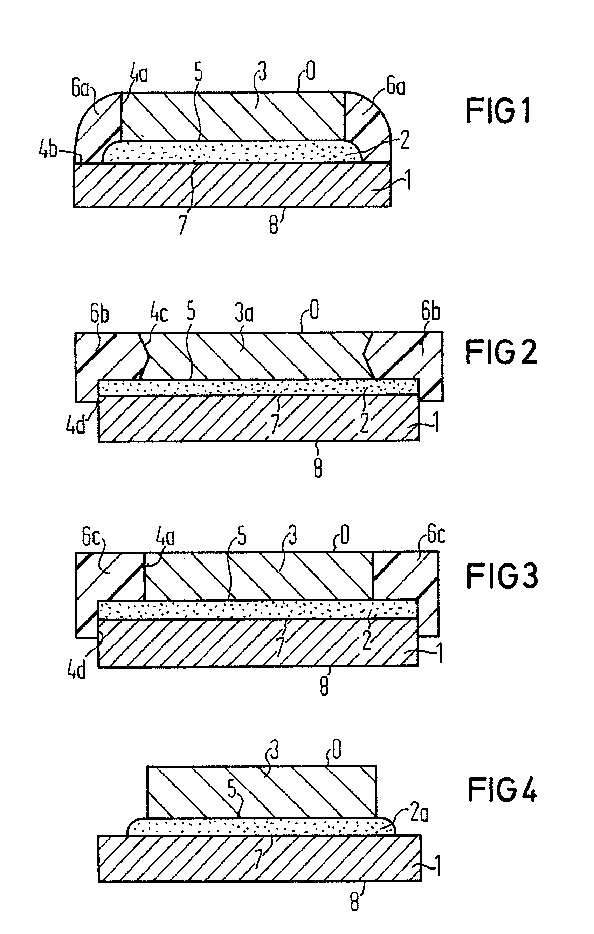

Bei einem ersten Verfahren wird, wie in Figur 1 gezeigt, ein, beispielsweise aus Molybdän bestehendes, Substrat 1 mit einer Zwischenschicht 2 versehen und auf diese wiederum ein Halbleiter 3 aufgebracht. Die Zwischenschicht 2 liegt zwischen der Halbleiteroberfläche 5 und der Substratoberfläche 7, die gegebenenfalls vorbehandelt sind und besteht selbst aus einem thermisch und elektrisch gut leitenden Pulver, beispielsweise Silberpulver, das beispielsweise als vorgesintere Folie vorliegt. Die seitliche Randfläche 4a des Halbleiters 3 wird erfindungsgemäß, wie in Figur 1 gezeigt, mit einem ringförmigen Außenbereich 4b der Substratoberfläche 7 durch einen ringförmigen, elastischen Wulst 6a, beispielsweise Silkonwulst, verklebt und abgedichtet.

Anstelle des, in Figur 1 gezeigten, elastischen Wulsts 6a kann eine in Figur 2 dargestellte, ringförmige Randpassivierung 6b eines Halbleiters 3a verwendet werden. Die Randpassivierung 6b besteht hierzu aus einem weichen und elastischen Kunststoff, beispielsweise Silikon, und ist so geformt, daß die, zur besseren Befestigung eine Einbuchtung aufweisende, seitliche Randfläche 4c des Halbleiters 3a mit einem Bereich 4d der seitlichen Randfläche des Substrats 1 verbunden und abgedichtet wird.

Besteht keine Randpassivierung, so kann ein, in Figur 3 dargestellter, aus einem weichen und elastischen Kunststoff, beispielsweise Silikon, vorgeformter Ring 6c verwendet werden. Der Kunststoffring 6c kann sowohl nach dem Aufbringen des Halbleiters 2 auf die Zwischenschicht 2 angebracht werden oder gemeinsam mit dem Halbleiter 3 aufgebracht werden. Ist der Kunststoffring 6c aufgebracht so muß er den Bereich zwischen der seitlichen Randfläche 4a des Halbleiters 3 und den Bereich 4d der seitlichen Randfläche des Substrats abdichten.

In einem folgenden erfindungsgemäßen Verfahrensschritt werden nun die mit Abdichtungen 6a, 6b oder 6c versehenen Anordnungen aus Halbleiter 3 oder 3a, Zwischenschicht 2, Substrat 1 in eine als Autoklav bezeichnete Apparatur eingebracht. Ein Autoklav ist ein beheizbares Druckgefäß, das in diesem Fall für einen Preßdruck von 300 bis 400 bar ausgelegt sein muß und am besten eine innenliegende Heizung haben soll. Besonders geeignet sind hierzu Anlagen für heiß-isostatisches Pressen (HIP).

Der Preßdruck eines im Autoklav befindlichen, chemisch inerten und nicht festen Mediums, beispielsweise Stickstoff oder Argon als gasförmiges und Silikonöl als flüssiges Medium, bewirkt jeweils Druckkräfte auf eine Oberfläche O der Halbleiter 3 oder 3a und auf eine Oberfläche 8 des jeweiligen Substrats 1. Die Abdichtungen 6a, 6b oder 6c verhindern das Aufbauen eines Gegendrucks in der Zwischenschicht 2; es können somit keine Gegenkräfte auf die Oberflächen 5, 7 bewirkt werden und infolgedessen wird die Anordnung aus Halbleiter, Zwischenschicht und Substrat zusammengepreßt. Durch den Preßdruck wird die Zwischenschicht 2 stark verdichtet und es entsteht eine Verbindung durch Drucksintern.

Wird auf eine Zwischenschicht 2 verzichtet und wird nur die gegebenenfalls vorbehandelte Halbleiteroberfläche 5 und gegebenenfalls vorbehandelte Substratoberfläche 7 aufeinandergepreßt, so entsteht in entsprechender Weise eine Verbindung durch Diffusionsschweißen. Die Vorbehandlung der Oberflächen 5, 7 kann hier beispielsweise durch galvanisches Auftragen oder Aufdampfen einer Edelmetall-Kontaktierungsschicht erfolgen.

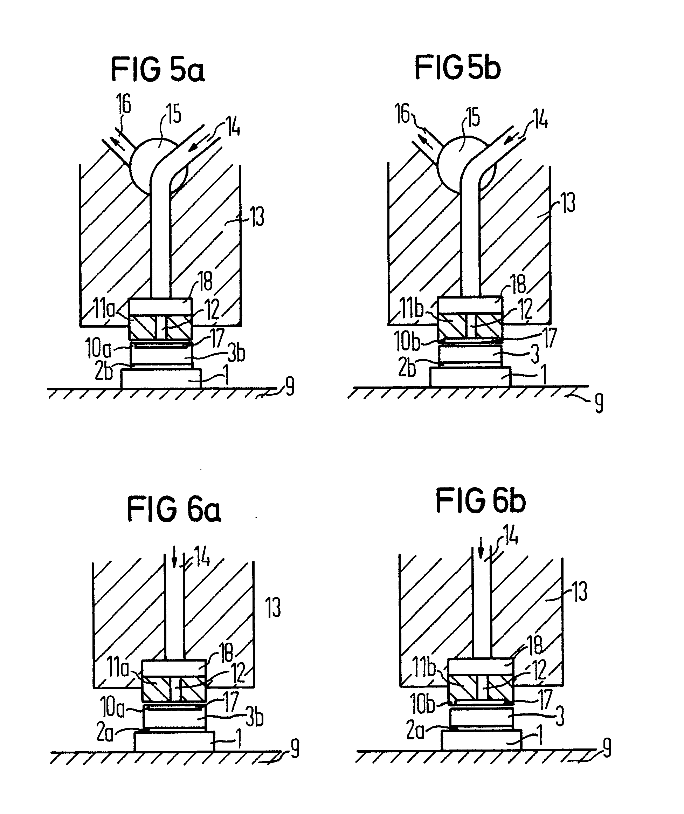

Durch ein zweites erfindungsgemäßes Verfahren kann bei einer, in Figur 4 dargestellten, bereits vorverbundenen Halbleiter/Substrat-Verbindung mit Hilfe einer Nachbehandlung durch berührungsfreies Pressen und bei geeigneter Temperatur ein Nachsintern zur Erhöhung der Verbindungsfestigkeit bewirkt werden. Das Vorverbinden der Halbleiter/Substrat-Verbindung erfolgt dabei beispielsweise ebenfalls durch berührungsfreies Pressen. Eine Abdichtung zwischen Halbleiter 3 und Substrat 1 ist insbesondere bei Leistungshalbleitern nicht erforderlich, da die Penetrationsgeschwindigkeit, selbst bei einem gasförmigen Druckmedium, in der, beispielsweise aus Silberpulver bestehenden, verdichteten Zwischenschicht 2a so gering ist, daß bei Halbleiterbauelementen, wie zum Beispiel bei Leistungshalbleiterbauelementen, erst nach vielen Minuten ein Druckausgleich eintritt. Das Pressen erfolgt dabei, wie beim ersten Verfahren, in einem Autoklav.

Da im Autoklav ein einheitlicher Druck herrscht, können gleichzeitig eine Vielzahl von Halbleitern mit Substraten verbunden oder eine Vielzahl von vorverbundenen Halbleiter/Substrat-Verbindungen nachbehandelt werden.

Das erste erfindungsgemäße Verfahren kann ebenfalls durch eine in Figur 5a bzw. Figur 5b beschriebene Anordnung durchgeführt werden. Bei dieser Anordnung befindet sich der Halbleiter 3b bzw. 3 zur Erwärmung auf einem Heizblock 9. Wie in Figur 5a gezeigt, weist der Halbleiter 3b einen leicht erhabenen, ringförmigen Außenbereich 10a auf, auf dem ein durchbohrter Preßkolben 11a ohne erhabenen Außenbereich liegt. Der Außenbereich kann hierzu beispielsweise aus Silikonlack bestehen. Bei der in Figur 5b gezeigten Anordnung hingegen besitzt ein durchbohrter Preßkolben 11b einen leicht erhabenen ringförmigen Außenbereich und der Halbleiter 3 weist dafür keinen entsprechenden Außenbereich auf. Die Halbleiter 3b und 3 können beim Verbinden durch Drucksintern mit einer sinterfähigen Zwischenschicht 2b, beispielsweise einem Silberschwamm, beschichtet sein. Die durchbohrten Preßkolben 11a und 11b besitzen jeweils eine Bohrung 12, die einen, vom zugehörigen Außenbereich 10a oder 10b ringförmig umschlossenen Innenbereich 17 mit dem Zylinderinnenraum 18 eines Zylinders 13 verbindet. Ein Dreiwegehahn 15 ermöglicht eine wahlweise Verbindung zwischen dem Zylinderinnenraum 18 und einem Einlaß 14 oder einem Auslaß 16.

Zur Durchführung des ersten erfindungsgemäßen Verfahrens, wird das Substrat 1 auf dem Heizblock 9 vorgeheizt, der durchbohrte Preßkolben 11a bzw. 11b so auf den Halbleiter 3b bzw. 3 aufgesetzt, daß eine Abdichtung zwischen durchbohrtem Preßkolben 11a bzw. 11b und Halbleiter 3b bzw. 3 bewirkt wird. Wird jetzt durch den Dreiwegehahn 15 der Auslaß 16 mit dem Zylinderinnenraum 18 verbunden, so wird der Zylinderinnenraum 18 und, über die Bohrung 12, auch der Innenbereich 17 evakuiert, was ein Ansaugen des Halbleiters 3b bzw. 3 bewirkt. Der Halbleiter 3b bzw. 3 kann nun, zusammen mit dem Preßkolben 11a bzw. 11b und dem Zylinder 13, exakt auf dem Substrat 1 positioniert werden, bevor mit Hilfe des Dreiwegehahnes 15 der Einlaß 14 mit dem Zylinderinnenraum 18 verbunden wird und sich der Preßdruck des chemisch inerten und nicht festen Mediums, beispielsweise Stickstoff oder Argon als gasförmiges und Silikonöl als flüssiges Medium, im Innenraum 17 zwischen Preßkolben und Halbleiter aufbaut und letzteren berührungsfrei auf das vorgeheizte Substrat 1 preßt.

Die Anordnung zur Durchführung des zweiten erfindungsgemäßen Verfahrens weist, wie in Figur 6a bzw. 6b dargestellt, eine unmittelbare Verbindung zwischen dem Einlaß 14 für das chemisch inerte und nicht feste Medium und dem Zylinderinnenraum 18 auf, da bei der Durchführung des zweiten erfindungsgemäßen Verfahrens ein Ansaugen zum exakten Positionieren wegfällt, weil das Substrat 1 mit dem Halbleiter 3b bzw. 3 unmittelbar oder durch die vorverdichtete Zwischenschicht 2a bereits zu einer Halbleiter/Substrat-Verbindung vorverbunden ist.

Bei Halbleiterbauelementen mit Kunststoffspritzgehäuse, kann die zu ihrer Herstellung erforderliche Kunststoffschmelze, beispielsweise eine heißhärtende Kunstharzmasse, gleichzeitig als chemisch inertes und nicht festes Medium für das erste oder zweite erfindungsgemäße Verfahren benutzt werden. Dies ist möglich, da das Umspritzen bei Temperaturen um 200°C und einem Druck von mehreren hundert bar bei einer Haltezeit von wenigen Minuten erfolgt.

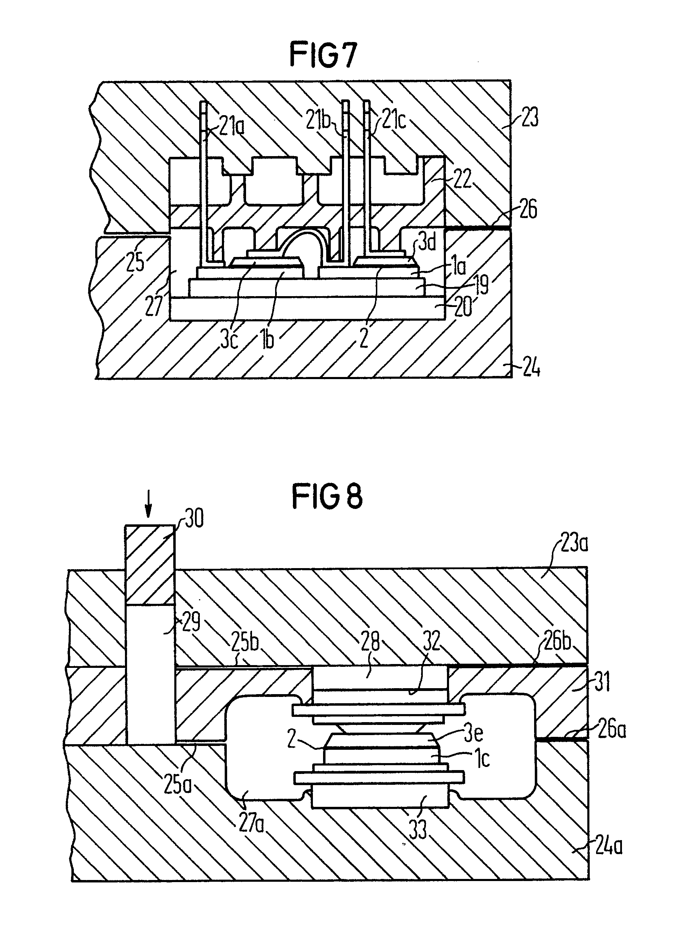

Figur 7 zeigt eine Anordnung zur Durchführung des ersten oder zweiten erfindungsgemäßen Verfahrens, bei der der Spritzdruck einer Kunststoffschmelze zum Verbinden der Halbleiter 3c und 3d mit den Substraten 1b und 1a durch eine Zwischenschicht 2 oder zum Nachbehandeln der bereits bestehenden Halbleiter/Substrat-Verbindungen 3c, 1b und 3d, 1a. Die in Figur 7 dargestellte Anordnung wird insbesondere zur Herstellung von Halbleitermodulen verwendet und besteht im wesentlichen aus einer oberen Spritzform 23 und einer unteren Spritzform 24, die zusammen eine Spritzkammer 27 bilden, einem Spritzkanal 25 um die Kunststoffschmelze zuzuführen und einem dünnen Entlüftungskanal 26. Vor jedem Spritzvorgang befindet sich eine Bodenplatte 20 in der Spritzform, auf die eine Isolierschicht 19 aufgelegt ist und diese wiederum trägt die Substrate 1b und 1a mit den durch die Zwischenschicht 2 bereits verbundenen oder noch zu verbindenden Halbleitern 2c und 3d. Die gegebenenfalls zur Verbindung vorbehandelten und mit Anschlußdrähten 21a bis 21c versehenen Teile werden durch Justierteile 22 aus Kunststoff gehalten und zentriert.

Bei der Durchführung des ersten oder zweiten erfindungsgemäßen Verfahrens dringt die unter dem Spritzdruck stehende Kunststoffschmelze durch den Spritzkanal 25 in die Spritzkammer 27 vor, umfließt die in der Spritzkammer befindlichen Teile und übt einen hydrostatischen Druck aus ohne aber wegen ihrer hohen Viskosität in die Zwischenschicht 2 einzudringen und einen Gegendruck aufzubauen.

Figur 8 zeigt eine weitere Anordnung zur Durchführung des ersten oder zweiten erfindungsgemäßen Verfahrens, bei der der Spritzdruck einer Kunststoffschmelze zum Verbinden eines Halbleiters 3e mit einem Substrat 1c durch eine Zwischenschicht oder zum Nachbehandeln der bereits bestehenden Halbleiter/Substrat-Verbindung 3e, 1c. Die in Figur 8 dargestellte Anordnung wird insbesondere zur Herstellung von Halbleiterbauelementen mit Scheibengehäuse verwendet und besteht im wesentlichen aus einer oberen Spritzform 23a, einer Zwischenform 31 und einer unteren Spritzform 24a, die gemeinsam eine Spritzkammer 27a bilden. Die Spritzkammer 27a ist über einen Spritzkanal 25a mit einer Preßkammer 29 verbunden, die einen Preßkolben 30 aufweist. Da die Spritzkammer 27a die Anordnung aus einem oberen Kontaktstück 32, dem Halbleiter 3e, dem Substrat 1c und einem unteren Kontaktstück 33 nur ringförmig umschließt, können keine Preßkräfte auf die Kontaktstücke 32, 33 durch die Kunststoffschmelze der Spritzkammer ausgeübt werden. Um auch bei dieser Anordnung einen Preßdruck durch die Kunststoffschmelze zu bewirken, ist erfindungsgemäß eine über einen Zusatzspritzkanal 25b mit der Preßkammer 29 verbundene Zusatzkammer 28 vorhanden. Die Verbindung der Zusatzkammer mit der Preßkammer könnte auch indirekt, beispielsweise durch einen Zusatzspritzkanal zwischen der Zusatzkammer und der Spritzkammer, gebildet sein. Reicht beispielsweise bei einer speziellen Halbleiter/Substrat-Anordnung eine Zusatzkammer nicht aus, so können mehrere direkt oder indirekt mit der Preßkammer verbundene Zusatzkammern vorgesehen werden. Die Spritzkammer 27a weist einen dünnen Entlüftungskanal 26a auf und die Zusatzkammer 28 einen dünnen Zusatzentlüftungskanal 26b, wobei beide Entlüftungskanäle 26a, 26b so dünn sein müssen, daß die Kunststoffschmelze nicht austreten kann.

Zur Durchführung des ersten oder zweiten erfindungsgemäßen Verfahrens wird in die untere Spritzform 24a die Anordnung aus dem oberen Kontaktstück 32, dem Halbleiter 3e, dem Substrat 1c und dem unteren Kontaktstück 33 eingebracht, daraufhin die Zwischenform 31 aufgesetzt und die Spritzform durch die obere Spritzform 23a verschlossen. Daraufhin wird die Preßkammer mit dem zu verspritzenden Kunststoff gefüllt und die Schmelze in die Form gespritzt. Nach dem Aushärten der Kunststoffschmelze wird die Spritzform geöffnet, das Kunststoffmaterial der Zusatzkammer vom Bauelement entfernt und das fertige Bauelement aus der Spritzform entnommen.

Eine Preßkammer kann dabei gleichzeitig mehrere Spritzformen mit der Kunststoffschmelze versorgen, damit mehrere Bauelemente in einem Arbeitsgang umspritzt werden können.

Das erste und zweite erfindungsgemäße Verfahren ist in erster Linie für die Verarbeitung von ganzen Halbleiterwafern gedacht, kann aber problemlos ebenfalls auf Halbleiterchips angewendet werden.

**Patentansprüche**

1. Verfahren zum Verbinden von einem Halbleiter mit einem Substrat durch Pressen, **dadurch gekennzeichnet,** daß ein zum Verbinden erforderlicher Preßdruck durch ein chemisch inertes und nicht festes Medium ausgeübt wird.

2. Verfahren zum Nachbehandeln von einer Halbleiter/Substrat-Verbindung durch Pressen, **dadurch gekennzeichnet,** daß ein zum Nachbehandeln erforderlicher Preßdruck durch ein chemisch inertes und nicht festes Medium ausgeübt wird.

3. Verfahren nach Anspruch 1, **dadurch gekennzeichnet,** daß Spalte zwischen dem Substrat (1) und dem Halbleiter (3) abgedichtet werden und daß in einem temperaturbeständigen, wärmeisolierten und druckfesten Gefäß der Halbleiter (3) mit dem Substrat (1) durch den in dem Gefäß herrschenden Druck verbunden wird.

4. Verfahren nach Anspruch 2, **dadurch gekennzeichnet,** daß in einem temperaturbeständigen, wärmeisolierten und druckfesten Gefäß eine Halbleiter/Substrat-Verbindung (3, 1) durch den in dem Gefäß herrschenden Druck nachbehandelt wird.

5. Verfahren nach Anspruch 3, **dadurch gekennzeichnet,** daß Spalte zwischen einem Substrat und einem Halbleiter durch einen Wulst (6a) aus einem weichen, temperaturbeständigen Feststoff, der den Halbleiter (3) und das Substrat (1) miteinander zugleich elastisch verklebt und verbindet, abgedichtet werden.

6. Verfahren nach Anspruch 3, **dadurch gekennzeichnet,** daß Spalte zwischen dem Halbleiter (3) und dem Substrat (1) durch einen vorgefertigten Ring (6c) aus einem weichen, temperaturbeständigen Feststoff abgedichtet werden.

7. Verfahren nach Anspruch 3, **dadurch gekennzeichnet,** daß eine vorhergehende ringförmige Randpassivierung (6b) des Halbleiters (3) so ausgebildet wird, daß damit gleichzeitig die Spalte zwischen dem Halbleiter (3) und dem Substrat (1) abgedichtet werden.

8. Verfahren nach Anspruch 3 oder 4, **dadurch gekennzeichnet,** daß in einem Arbeitsgang mehrere Halbleiter auf mindestens ein Substrat gepreßt werden.

9. Verfahren nach einem der Ansprüche 5 bis 7, **dadurch gekennzeichnet,** daß die zur Abdichtung dienenden Mittel (6a, 6b und 6c) zugleich zur Ausrichtung und/oder Fixierung des Halbleiters auf dem Substrat verwendet werden.

10. Verfahren nach Anspruch 1 oder 2, **dadurch gekennzeichnet,** daß sich in einem Zylinder (13) ein loser, durchbohrter Preßkolben (11a) befindet, daß der durchbohrte Preßkolben auf den Halbleiter (3b) gedrückt wird und durch einen leicht erhabenen, ringförmigen Außenbereich (10a) des Halbleiters (3b) eine Abdichtung zwischen dem Preßkolben (11a) und dem Halbleiter (3b) bewirkt wird, daß das im Zylinder (13) befindliche Medium durch den durchbohrten Preßkolben (11a) gedrückt wird und den abgedichteten Innenraum (17) zwischen dem Preßkolben (11a) und dem Halbleiter (3b) ausfüllt, und daß somit der zugehörige Innenbereich des Halbleiters (3b) berührungsfrei auf das Substrat (1) gepreßt wird.

11. Verfahren nach Anspruch 1 oder 2, **dadurch gekennzeichnet,** daß sich in einem Zylinder (13) ein loser, durchbohrter Preßkolben (11b) befindet, daß der durchbohrte Preßkolben (11b) auf den Halbleiter (3) gedrückt wird und durch einen leicht erhabenen, ringförmigen Außenbereich (10b) des Preßkolbens (11b) eine Abdichtung zwischen dem Preßkolben (11b) und dem Halbleiter (3) bewirkt wird, daß das im Zylinder (13) befindliche Medium durch den durchbohrten Preßkolben (11b) gedrückt wird und den abgedichteten Innenraum (17) zwischen dem Preßkolben (11b) und dem Halbleiter (3) ausfüllt, und daß somit der zugehörige Innenbereich des Halbleiters (3) berührungsfrei auf das Substrat (1) gepreßt wird.

12. Verfahren nach Anspruch 10 oder 11, **dadurch gekennzeichnet,** daß beim Verbinden des Halbleiters (3b oder 3) mit dem Substrat (1) durch einen Unterdruck im Zylinderinnenraum (18) des Zylinders (13) über den durchbohrten Preßkolben (11a oder 11b) ein Ansaugen des Halbleiters (3b oder 3) bewirkt wird, um diesen anschließend exakt zu positionieren.

13. Anordnung zur Durchführung des Verfahrens nach Anspruch 10 oder 11, **dadurch gekennzeichnet,** daß der Preßkolben (11a oder 11b) aus einem temperaturbeständigen und warmeisolierenden Material gefertigt ist.

14. Anordnung nach Anspruch 13, **dadurch gekennzeichnet,** daß der Preßkolben (11a oder 11b) aus einem elastischen Kunststoff gefertigt ist.

15. Verfahren nach Anspruch 1 oder 2, **dadurchgeke nnzeichnet,** daß der Preßdruck durch eine flüssige Kunststoffschmelze bewirkt wird, wobei die Kunststoffschmelze nach dem Erhärten zumindest bereichsweise mit dem Halbleiter (3c, 3d oder 3e) und dem Substrat (1a, 1b oder 1c) verbunden bleibt und Bestandteil eines fertigen Bauelementes ist.

16. Verfahren nach Anspruch 15, **dadurch ge-kennzeichnet,** daß die flüssige Kunststoff-schmelze den Halbleiter (3c, 3d oder 3e) und das Substrat (1a, 1b oder 1c) auf eine, für das Verfahren ausreichende, Temperatur erwärmt.

17. Verfahren nach Anspruch 11, **gekennzeichnet dadurch,** daß in einem Arbeitsgang mehrere Halbleiter (3c und 3d) auf mindestens ein Substrat (1a und 1b) gepreßt werden.

18. Anordnung zur Durchführung des Verfahrens nach Anspruch 15, **dadurch gekennzeichnet,** daß in einer Spritzform zusätzlich zu einer Spritzkammer (27 oder 27a) mindestens eine Zusatzkammer (28) vorgesehen ist, daß die Zusatzkammer (28) und die Spritzkammer (27 oder 27a) über Kanäle mit einer Preßkammer (29) verbunden sind und daß die Zusatzkammer (28) so angeordnet ist, daß ein ausreichender Preßdruck auf den Halbleiter (3c, 3d oder 3e) und das Substrat (1a, 1b oder 1c) bewirkt wird.

**FIG 1**

**FIG 2**

**FIG 3**

**FIG 4**

## FIG 5a

## FIG 5b

## FIG 6a

## FIG 6b

# FIG 7

# FIG 8